# EUROPEAN PATENT SPECIFICATION

(11) **EP 0 363 297 B1**
(45) Date of publication and mention of the grant of the patent: **23.03.1994**
(21) Application number: 89480113.3
(22) Date of filing: 26.07.1989
(51) Int. Cl.: H01L 21/60, H01L 21/90, H01L 23/522

(54) **Improved contact stud structure for semiconductor devices**
Kontaktständerstruktur für Halbleitervorrichtungen
Structure du contact bouton modifié pour dispositifs semi-conducteurs

(30) Priority: 03.10.1988 US 252836
(43) Date of publication of application: 11.04.1990
(73) Proprietor: International Business Machines Corporation, Armonk, N.Y. 10504 (US)
(72) Inventor: Huang, Hung-Chang Ward, San Jose, CA 95120 (US); Totta, Paul Anthony, Poughkeepsie, NY 12603 (US)
(74) Representative: Klein, Daniel Jacques Henri

(56) References cited:
- EP-A- 0 224 013
- EP-A- 0 279 588
- SOLID STATE TECHNOLOGY, vol. 30, no. 4, April 1987, pages 155-162, Port Washington, NY, US; Y. PAULEAU: "Interconnect materials for VLSI circuits"
- Semiconductor Devices, Physics and Technology S.M. Sze. J. Wiley and Sons 1985 p. 371

## Description

In general, this invention relates to a method for producing multi-level, co-planar, metal/insulator interconnection layers for high performance semiconductor chips and more particularly to a method for making contact studs for interconnecting the metallization layers at different levels in said semiconductor chips.

A semiconductor chip consists of an array of devices whose contacts are interconnected by patterns of metal wires. In VLSI chips these metal patterns are multi-layered and separated by layers of an insulating material. Interconnections between the layers of metal wiring patterns are made by holes (or via-holes) which are etched through the insulator. Typical chip designs consist of one, two or three wiring levels.

The forming of an interconnection metallurgy system for integrated circuit devices has conventionally been done by blanket depositing a metal layer, forming a photoresist layer on the metal layer, exposing the resist to the desired metallurgy pattern, developing the resist, and subsequently etching the exposed portions of the underlying metal layer to thereby form the interconnection wiring. The wiring pattern was subsequently covered by an insulating layer, planarized and then another metallurgy pattern was then formed on said insulating layer. Contact between layers was made through via holes, until the desired interconnection wiring diagram was complete.

Interconnection of the multi-level wiring structure to the device contacts on the substrate was typically made by the incorporation of an access wiring layer.

In an effort to further reduce device processing time and reduce size, access wiring layers were replaced by via studs or vertical wires, known in the art as studs. Studs were now able to be placed directly on top of the device contacts to make interconnection with the above multi-level wiring system.

Studs are known to be formed by using what is termed an "expendable mask method" or "lift-off method", which was initially described and claimed in U. S. Patent No. 2,559,389. Improvements to the basic lift-off method have been made, as for example in commonly assigned in U. S. Patent Nos. 3,849,136 filed August 31, 1973 and 3,873,361 filed November 29, 1973. However, the lift-off technique for forming stud metallurgy does not totally overcome the problems of: uniform deposition of stud metallurgy, planarity problems associated with achieving uniform stud height, high aspect ratio stud depositions, and electromigration tendencies of the preferred stud metallurgies.

An example of the problems associated with stud formation can be seen from the use of lift-off with aluminum as the stud metal. The aluminum must be deposited by evaporation; however, evaporation of aluminum is known to create problems of voids and irregularities in its formation.

Another problem associated with stud formation is the structural irregularities which are known to be created by the nature of the master-slice processing. For example, as master-slice processing causes variation in depth of contacts, the height of the deposited studs becomes variable such that the aluminum studs must be ion etched back to form a planar surface. (See, for example, in U. S. Patent No. 4,541,169.).

While there have been many techniques proposed for achieving planarity of studs, these techniques have all been based on the use of Ion Etch back with lift-off, (For example, in U. S. Patent Nos. 4,410,622; 4,470,874, and 4,541,169) wherein the results have not achieved consistent planarity and the methods have been limited to larger line widths and studs.

Moreover, with aluminum as a stud metal, there are added problems in terms of contact alloying/ penetration, electromigration, and silicon particle formation. Silicon will form particles and thin films in the contact holes which results in the aluminum being isolated from the substrate surface. Moreover, with the ever-continuing reduction of dimensions in the device multi-level interconnection system, limits as to insulation and electromigration tolerances in using aluminum are encountered.

Electromigration problems associated with aluminum deposited on silicon type substrates have been proposed to be cured by use of tungsten films as diffusion barriers (M. L. Green and R. A. Levy, Technical Proceedings, SEMICON/EAST 85, Semiconductor Equipment and Materials Institute Meeting, September, 1985, pp. 57-63). However, defects "wormholes" originating at the tungsten/silicon interface and problems with preferential erosion of N⁺ implanted silicon versus P⁺ implanted silicon from LPCVD tungsten deposition have taught against the solitary use of LPCVD tungsten as the contact stud filler metallurgy.

In a more recent publication (U. Fritsch, G. Higelin, G. Enders and W. Muller; Technical Proceedings, V-MIC Conference Meeting; June 13, 14, 1988, pp. 69-75), the authors propose one possible solution to the defects associated with deposition of CVD tungsten in CMOS devices. Therein, the authors propose first depositing a titanium/titanium nitride diffusion barrier by sputtering followed by a CVD tungsten layer. However, this structure does not create a seed layer which matches the atomic structure of the CVD refractory metal which is to follow. Therefore, there can be interface problems between the CVD refractory fill metal and the titanium nitride layer such as mechanical separation and/or electrical resistance.

EP-A- 279588 discloses a stable low resistance contact formed in a contact hole through an insulating layer, e.g. SiO₂, region of a silicon substrate comprises: (a) an adhesion and contacting layer of Ti; (b) a barrier layer formed over (a) and comprising a material selected from W, Mo, TiW, TiN, TiWN, WN, MoN, Cr, Cr/Cr oxide and BN; and (c) a conductive material selected from W, or Mo, or dropped polysilicon, and at least substantially filling contact hole.

EP-A- 224013 discloses a further method for producing coplanar multi-level metal/insulator films on a substrate.

It is therefore an object of the present invention to produce a method for producing a multi-level co-planar metal and insulation interconnection system for VLSI semi-conductor devices.

It is a further object of the present invention to produce planar studs for contacting the substrate to the first level of interconnection wiring.

It is a still further object of the present invention to produce interconnect studs, incapable of being produced with liftoff tolerances (i.e., stud widths of less than 1.5 µm).

It is another object of the present invention to produce substrate contact studs of a non-reactive metal for void free deposition with low electromigration characteristics.

It is still another object of the present invention to provide a substrate contact stud structure useable with different component contacts.

The object of the invention is achieved by the process as claimed in claim 1.

### SUMMARY OF THE INVENTION

Onto a substrate which has been processed to the point of being ready for the contact stud metallurgy, an insulator is blanket deposited. This insulator is, then, planarized and portions are then selectively removed at predetermined locations to expose the substrate surface for contact.

A reactive adhesion layer is, then, blanket deposited over said insulator and into said contact openings.

A seed layer is, then, deposited over said adhesion layer. Both the adhesion and seed layers are sputter deposited. Preferably, the adhesion layer is a transition metal capable of reducing Si0₂ and the seed layer is a refractory metal. However, depending on the specific transistor component to which contact is to be made, the adhesion layer can either be a transition metal or an alloy of the reactive metal with a refractory metal.

A refractory metal, such as, tungsten, is then chemically vapor deposited (CVD) as a filler layer to complete the formation of the contact studs. The surface is again planarized such that said insulator and said studs form a co-planar surface.

Successive upper layers of interconnecting metallization can now be fabricated onto said contact studs. Thus, onto said studs is deposited wiring metallurgy such that contact to said substrate is made through the previously deposited stud.

Fig. 1 is a cross-sectional representation of a portion of a semiconductor chip processed through forming a device contact on said chip.

Fig. 2 shows the semiconductor structure of Fig. 1 with the deposition of an etch stop layer onto the substrate surface.

Fig. 3 shows the semiconductor structure of Fig. 2 wherein an insulator has been deposited over the semiconductor chip.

Fig. 4 shows the semiconductor structure of Fig. 3 wherein the insulator has been planarized.

Fig. 5 shows the semiconductor structure of Fig. 4 wherein the device contacts have been exposed.

Fig. 6 shows the semiconductor structure of Fig. 5 wherein a metal has been deposited over the surface.

Fig. 7 shows the semiconductor structure of Fig. 6 wherein the contact stud metallurgy has been deposited over the diffusion barrier.

Fig. 8 shows the semiconductor structure of Fig. 7 wherein the metal and insulator has been made to be co-planar.

Fig. 9 shows the semiconductor structure of Fig. 8 showing the deposition of the wiring metallurgy.

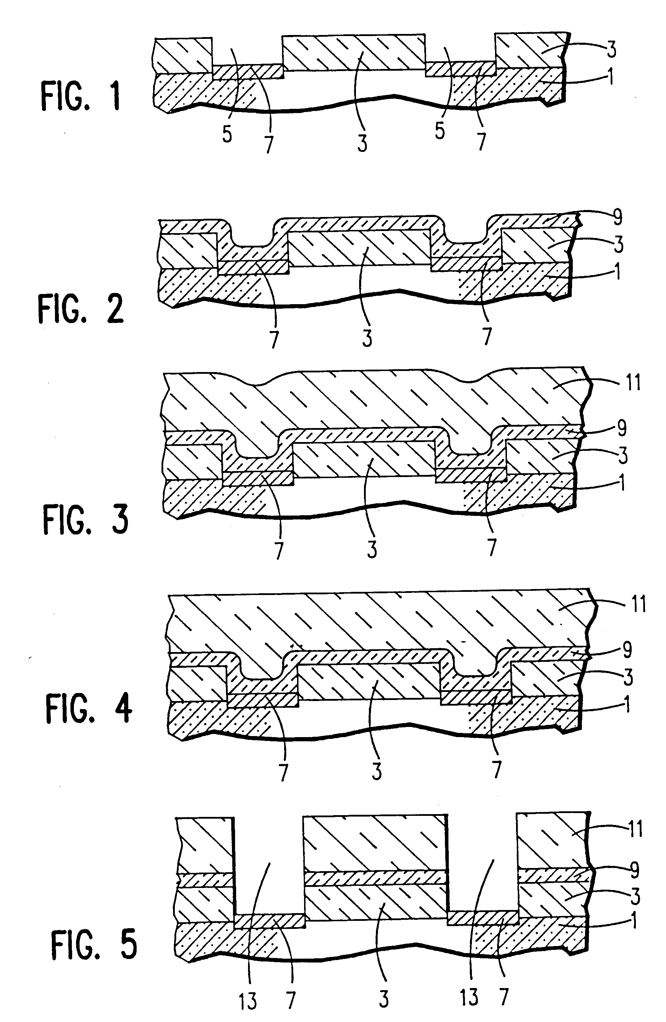

Referring now to Fig. 1, there is shown a substrate 1, which is typically monocrystalline silicon or other semiconductor material with an overlying layer 3 of a dual dielectric layer, as for example Si0₂/Si₃N₄. Preferably, the dielectric layer is comprised of a layer of thermally grown Si0₂ about 1000Å thick onto which is thermally grown a Si₃N₄ layer of about 1500Å.

The substrate 1 in the preferred embodiment of the process of the invention is an integrated circuit device having active and passive devices fabricated therein and means (not shown) for electrically isolating the devices from each other. In this application, layer 3 is provided with contact openings 5 for making contact to contact area 7 (e.g., PtSi).

Referring now to Fig. 2, an etch stop layer 9 has been conformably deposited over the dielectric layer 3 and the substrate 1. The etch stop layer 9 can be of any suitable inorganic material that will conformally blanket and adhere to the surface of the substrate and dielectric layer, while also presenting a significant difference to etch resistance than the subsequent overlying material.

As shown in Fig. 3, onto said etch stop layer 9 is deposited a second layer of insulation 11. For example, sputtered or chemically vapor deposited (CVD) Si0₂ or borophosphosilicate glass (BPSG) or phosphosilicate glass (PSG) can be placed down over the structure shown in Fig. 2. It should be recognized by those skilled in the art that the thickness of this layer 11 determines the thickness of the level of metallization to be formed in the channels which are to be etched into layer 11 for the formation of the stud metallurgy. Next, the layer 11 is planarized by any conventional planarizing technique including Reactive Ion Etching (RIE) etch-back as shown in Fig. 4.

Referring now to Fig. 5, once the insulator surface has been planarized, via-holes or studs holes 13 are formed in layer 11 by using standard photolithographic and RIE techniques. The intended stud pattern is then transferred to the etch stop layer 9 by wet or RIE etch techniques, although the latter are preferred especially where fine dimensions are required. Other possible techniques of forming the via-holes or interconnection metallurgy pattern include projected laser assisted etching, sputtering techniques or reactive ion beam etching. Both layers 9 and 3 are opened to expose the substrate contact 7. It should be noted that while Figure 5 shows the contact area of the same width as the contact hole 5, the stud can be larger than the area 7 and/or can even connect two or more holes.

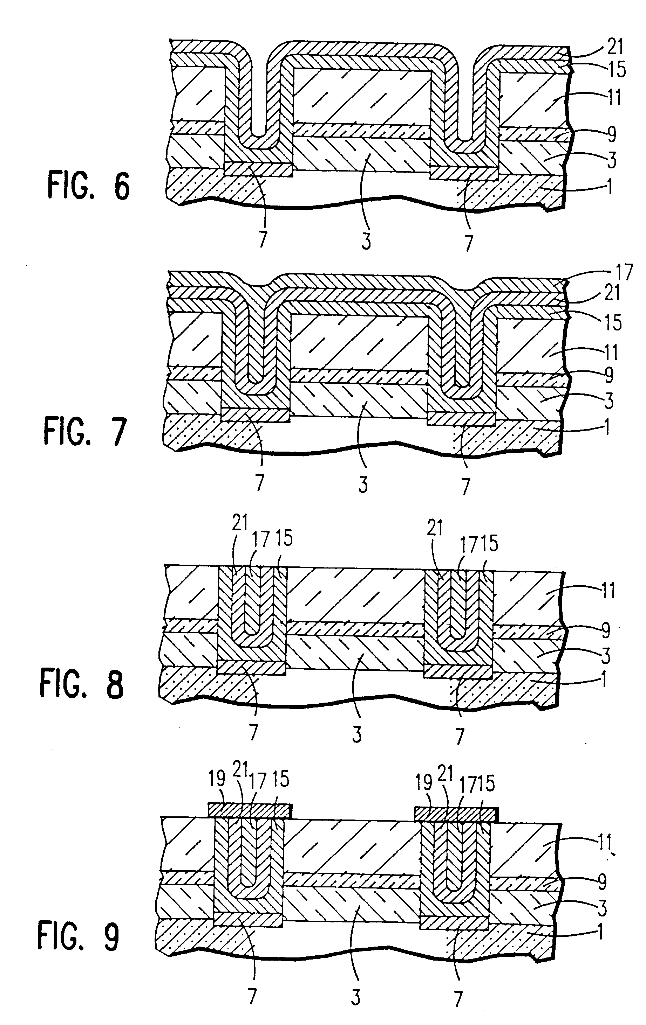

After the contact holes are defined, an adhesion and reactive layer 15 is sputtered or evaporated over the structure of Fig. 5 as shown in Fig. 6. The adhesion metal is deposited to be around 200Å to 1000Å thick. In the preferred embodiment, titanium is used as the adhesion metal for emitter contacts which contacts are made directly to the silicon. Those skilled in the art will recognize that reactive metal as used herein implies the capability to either reduce Si0₂ and/or to form an ohmic or Schottky barrier contact without forming silicides. Other metals are also well suited for use as the adhesion and reactive metal including any of the transition metals. However, it is noted that the exact adhesion metal layer to be used will vary with the specific component contact to be structured.

For example, if the component of the integrated circuit is a low barrier height Schottky barrier diode (LSBD), it is necessary to use either a pure reactive metal (e.g., titanium) or an alloy of a reactive metal, a refractory metal (e.g. TiW alloy with 10%Ti and 90%W). This layer is, then, followed by a seed layer of pure refractory metal (e.g., sputtered tungsten).

For other contacts such as those for high barrier height Schottky barrier diodes (HSBD), base, collector and resistors; the contact areas 7 may have platinum deposited therein, which forms platinum silicide. In these contacts, only the sputtered refractory seed layer is required.

Referring again to Figure 6, onto said adhesion and reactive layer 15 is sputtered or evaporated, a metal seed layer 21. This seed layer 21 is typically about 1000Å thick, but this is an approximation and the actual thickness can vary depending on the ability of the seed layer to prevent penetration of silicon to the subsequent filler layer.

In addition to providing a diffusion barrier to the silicon, the seed layer also acts as the nucleation layer for deposition of the filler layer 17. In the preferred embodiment, the seed layer is a metal of the class of refractory metals (i.e., tungsten, molybedenum, tantalum, etc.).

Onto said seed layer 21 is, then, chemically vapor deposited the contact stud filler metallurgy 17. The contact stud metallurgy is deposited so as to overlie the surface as shown in Fig. 7. The thickness of the contact stud metallurgy is at least as great as the stud via. Similar to the metallurgy of the seed layer, the refractory metals (e.g., tungsten, molybedenum, etc.) are the preferred metals for the contact studs.

As seen in Fig. 8, once the filler 17 metal has been deposited, the contact stud structure can then be planarized. A number of techniques exist for planarizing dis-similar layered structures with large removal rate ratios for combination of metals and dielectric materials. Possible techniques include but are not limited to RIE Etch, etc. By these techniques, the overlying adhesion, seed and filler layers are removed such that the surface of the insulator contact and metallurgy are co-planar.

Next, interconnection channels are defined by standard photolithography in a resist overlayer (not shown). In places where a stud via connection to overlying metallization is desired, the respective channel opening in the overlayer must be aligned with and at least, partially cover a contact stud.

As shown in Fig. 9, in one specific type of embodiment after the channels are defined in the photoresist, the overlying level of metallization 19 is deposited over the structure. The photoresist and excess metal is removed leaving interconnection metallurgy 19. However, it should be recognized by those skilled in the art that while an additive lift-off process has been described, it is also possible to practice this step of the process with a subtractive process (i.e., RIE or wet etch).

Onto said interconnection metallurgy is then deposited a layer of insulating material, for example, sputtered Si0₂ or CVD oxide. With the Si0₂ insulation, via-openings can be etched therein to contact the interconnection metallurgy. Then, stud metallurgy is sputter deposited into said via openings and overlying said insulation. Preferably, at this level, the stud metallurgy base is the same metallurgy as the interconnection metallurgy. This is, preferably, an Al-Cu based alloy.

The overlying metallurgy is then planarized to the insulator surface in preparation for the next levels of personalization. The preceding wiring process steps can then be repeated to form successive layers on the substrate.

## Claims

1. A process for making a contact stud onto a semiconductor substrate (1) having a patterned dielectric layer (3) formed thereupon having a set of first openings (5) exposing determined regions of the said substrate where a contact is to be made comprising the steps of:
a) depositing an etch-stop layer (9) of a first insulator material with selective etch properties with respect to the dielectric layer to be subsequently deposited thereupon;
b) depositing a planarizing layer (11) of a second insulator material onto said etch-stop layer, which substantially determines the thickness of the stud to be subsequently formed;
c) forming a set of second openings (13) in said planarizing layer and said etch-stop layer at exposed region location to expose said determined regions of said substrate;
d) depositing an adhesion layer (15) of a first metal in said second openings, said first metal being adhesive thereto and lining said second openings;
e) depositing a seed layer (21) of a second metal conformally onto said first metal layer;
f) depositing a filler layer (17) of a third metal conformally onto said second metal layer and filling said opening in said insulator layer and thereby forming said contact stud; and
g) planarizing the structure to have the metal studs coplanar with the planarizing layer top surface.

2. The process of claim 1 wherein said first metal is selected in the group of transition metals, said second and third metals being selected from the group comprising refractory metals.

3. The process of claim 1 or 2 wherein said planarizing layer is planarized prior to performing step c).

4. The process of claim 1 or 2 wherein said first metal is reactive with said substrate.

5. The process of claim 1 or 2 wherein prior to step a) Pt-Si contacts are formed in the first openings.

6. The process of any above claim wherein said substrate is silicon.

7. The process of any above claim wherein said patterned dielectric layer consists of a bottom layer of SiO₂ and of a top layer of Si₃N₄.

## Patentansprüche

1. Verfahren zum Herstellen eines Kontaktstifts auf einem Halbleitersubstrat (1) mit einer darauf gebildeten, strukturierten dielektrischen Schicht (3), die einen Satz von ersten Öffnungen (5) aufweist, die vorbestimmte Bereiche des Substrats freilegen, an denen ein Kontakt herzustellen ist, das die folgenden Schritte beinhaltet:
a) Aufbringen einer Ätzstoppschicht (9) aus einem ersten Isolatormaterial mit hinsichtlich der nachfolgend darauf aufzubringenden dielektrischen Schicht selektiven Ätzeigenschaften;
b) Aufbringen einer Planarisierungsschicht (11) aus einem zweiten Isolatormaterial auf die Ätzstoppschicht, die im wesentlichen die Höhe des nachfolgend zu bildenden Stiftes bestimmt;
c) Bilden eines Satzes von zweiten Öffnungen (13) in der Planarisierungsschicht und der Ätzstoppschicht an der Stelle eines freigelegten Bereiches, um die vorbestimmten Bereiche des Substrats freizulegen;
d) Aufbringen einer Haftschicht (15) aus einem ersten Metall in den zweiten Öffnungen, wobei das erste Metall daran haftet und die zweiten Öffnungen auskleidet;
e) gleichmäßiges Aufbringen einer Kristallkeimschicht (21) aus einem zweiten Metall auf die erste Metallschicht;
f) gleichmäßiges Aufbringen einer Füllschicht (17) aus einem dritten Metall auf die zweite Metallschicht sowie Füllen der Öffnung in der Isolatorschicht und dadurch Bilden des Kontaktstifts und
g) Planarisieren der Struktur, damit die Metallstifte koplanar zu der Oberseite der Planarisierungsschicht sind.

2. Verfahren nach Anspruch 1, wobei das erste Metall aus der Gruppe der Übergangsmetalle und das zweite und dritte Metall aus der Gruppe ausgewählt werden, die hochschmelzende Metalle beinhaltet.

3. Verfahren nach Anspruch 1 oder 2, wobei die Planarisierungsschicht vor der Durchführung des Schritts c) planarisiert wird.

4. Verfahren nach Anspruch 1 oder 2, wobei das erste Metall gegenüber dem Substrat reaktiv ist.

5. Verfahren nach Anspruch 1 oder 2, wobei vor dem Schritt a) in den ersten Öffnungen Pt-Si-Kontakte gebildet werden.

6. Verfahren nach einem der vorhergehenden Ansprüche, wobei das Substrat aus Silizium besteht.

7. Verfahren nach einem der vorhergehenden Ansprüche, wobei die strukturierte dielektrische Schicht aus einer unteren Schicht aus SiO₂ und einer oberen Schicht aus Si₃N₄ besteht.

## Revendications

1. Procédé pour former une lame de contact sur un substrat semiconducteur (1) ayant une couche isolante à motifs (3) qui le recouvre munie d'un ensemble de premières ouvertures (5) exposant des zones déterminées du dit substrat où un contact doit être produit, comprenant les étapes consistant à :
a) déposer une couche d'arrêt d'attaque (9) d'un premier corps isolant ayant des propriétés d'attaque sélectives au regard de la couche isolante devant la recouvrir ultérieurement;
b) déposer une couche planarisante (11) d'un second corps isolant sur ladite couche d'arrêt d'attaque, qui détermine substantiellement l'épaisseur de la lame qui sera formée ultérieurement;
c) former un ensemble de secondes ouvertures (13) dans ladite couche planarisante et ladite couche d'arrêt d'attaque sur l'emplacement des zones exposées pour exposer les dites zones déterminées du dit substrat;
d) déposer une couche d'adhérence (15) d'un premier métal dans les dites secondes ouvertures, ledit premier métal adhérant à, et recouvrant les dites secondes ouvertures;
e) enrober ladite couche de premier métal d'une couche de germe (21) d'un deuxième métal;
f) enrober ladite couche de deuxième métal d'une couche de remplissage (17) d'un troisième métal et remplir ladite ouverture dans ladite couche isolante pour former ladite lame de contact; et
g) aplanir la structure pour que les lames de métal soient coplanares avec la surface supérieure de la couche planarisante.

2. Procédé selon la revendication 1, dans lequel ledit premier métal est choisi dans le groupe des métaux de transition, les dits deuxième et troisième métaux étant choisis dans le groupe comprenant les métaux réfractaires.

3. Procédé selon la revendication 1 ou 2, dans lequel ladite couche planarisante est planarisée avant d'exécuter l'étape c).

4. Procédé selon la revendication 1 ou 2, dans lequel ledit premier métal réagit avec ledit substrat.

5. Procédé selon la revendication 1 ou 2, dans lequel des contacts Pt-Si sont formés dans les premières ouvertures avant l'étape a).

6. Procédé selon l'une quelconque des revendications précédentes dans lequel le substrat est en silicium.

7. Procédé selon l'une quelconque des revendications précédentes, dans lequel ladite couche isolante à motifs comprend une couche inférieure de SiO₂ et une couche supérieure de Si₃N₄.
